# FASCICULE DE BREVET EUROPEEN

(11) **EP 1 461 190 B1**
(45) Date de publication et mention de la délivrance du brevet: **26.10.2011**
(21) Numéro de dépôt: 02799856.6
(22) Date de dépôt: 31.12.2002
(51) Int. Cl.: B28D 5/00

(54) **DISPOSITIF DE COUPE DE COUCHE D'UN SUBSTRAT ET PROCÉDÉ ASSOCIÉ**
VORRICHTUNG ZUM ABTRENNEN EINER SCHICHT VON EINEM SUBSTRAT UND VERFAHREN DAFÜR
DEVICE FOR CUTTING A SUBSTRATE LAYER AND CORRESPONDING METHOD

(30) Priorité: 03.01.2002 FR 0200024
(43) Date de publication de la demande: 29.09.2004
(73) Titulaire: S.O.I.Tec Silicon on Insulator Technologies, 38190 Bernin (FR)
(72) Inventeur: RAYSSAC, Olivier, F-38100 Grenoble (FR); LETERTRE, Fabrice, F-38000 Grenoble (FR)
(74) Mandataire: Le Forestier, Eric
(86) Numéro de dépôt international: PCT/FR2002/004594
(87) Numéro de publication internationale: WO 2003/059590

(56) Documents cités:
- EP-A- 1 107 295
- FR-A- 2 785 217
- FR-A- 2 796 491
- US-B1- 6 221 740
- US-B1- 6 284 631

## Description

La présente invention concerne de manière générale le traitement des matériaux, et plus particulièrement de substrats pour l'électronique, l'optique ou l'optroélectronique.

Plus précisément, l'invention concerne un procédé de coupe selon le préambule de la revendication 1 et un dispositif de coupe selon le préambule de la revendication 9. Un tel procédé et un tel dispositif sont connus de US 6221740.

On précise que par « coupe » on entend dans ce texte l'opération consistant à diviser en deux parties physiquement disjointes un même élément ou ensemble, et à garantir que lesdites parties ne se réunissent pas à nouveau.

Le document FR 2 796 491 enseigne de réaliser au moins une cavité dans la région de l'interface, la cavité étant ensuite utilisée pour initier une coupe des deux couches définies par l'interface.

Une limitation de l'enseignement de ce document est qu'il ne permet que la coupe de couches qui ont été préalablement collées ensemble, l'interface de fragilisation étant nécessairement une interface de collage.

Or, il serait avantageux de pouvoir mettre en oeuvre un procédé du type mentionné ci-dessus pour réaliser la coupe de couches séparées par une interface de fragilisation de type quelconque.

Il serait ainsi avantageux de pouvoir mettre en oeuvre un procédé du type mentionné ci-dessus, par exemple pour couper des couches séparées par une interface de fragilisation qui a été définie par une implantation d'espèces telles que des ions ou des atomes dans un substrat de matériau (les deux couches étant alors réalisées dans le même matériau).

En effet, une manière de définir une interface de fragilisation dans un substrat du type utilisé pour l'électronique, l'optique ou l'optroélectronique, consiste à implanter des espèces telles que des ions d'hydrogène dans la masse du substrat avec une énergie d'implantation contrôlée, de manière à définir précisément la profondeur d'implantation des espèces.

Un tel substrat (nommé « wafer » selon la terminologie anglo-saxonne répandue) peut être notamment en un matériau semiconducteur tel que le silicium.

Il est également possible de réaliser l'interface de fragilisation par tout autre moyen connu en soi, par exemple en construisant une région intermédiaire de matériau poreux entre deux régions de matériau dense, en constituant une couche d'oxyde enterrée dans un substrat (par exemple un substrat de type SOI (Silicon On Insulator selon la terminologie anglo-saxonne répandue).

Et le collage de deux couches n'est ainsi qu'une manière particulière de réaliser une interface de fragilisation entre deux couches.

Un but de l'invention est ainsi de permettre de mettre en oeuvre un procédé du type mentionné ci-dessus, pour couper un ensemble à couper au niveau d'une interface de fragilisation qui a été réalisée par un des moyens évoqués ci-dessus, ou par tout moyen connu en soi.

On précise qu'on connaît par ailleurs des procédés permettant de couper des couches séparées par une interface de fragilisation définie par implantation. On trouvera un exemple d'un tel procédé dans le document US 6 221 740.

Mais ce procédé ne présente pas les avantages spécifiques du type de procédé décrit dans le document FR 2 796 491.

En particulier, ce procédé n'enseigne pas de contrôler précisément la pression dans deux régions différentes (correspondant à la région de haute pression et à la région de basse pression évoquées ci-dessus).

Or un tel contrôle est important pour conduire les opérations de coupe précisément et en évitant les risques de dégradation sur des wafers qui sont fragiles et dont on attend en sortie de coupe un état de surface de qualité extrêmement haute.

En outre, US 6 221 740 ne présente pas un type avantageux de structure tel que décrit dans FR 2 796 491, qui permet non seulement de définir au moins une région de haute pression et une région de basse pression dans lesquelles on peut précisément contrôler la pression, mais permet en outre à l'ensemble à couper de se déformer très librement lors de la coupe (du fait notamment de l'absence de contact sur une partie importante des faces principales de cet ensemble).

Ainsi, les structures des dispositifs de FR 2 796 491 et de US 6 221 740 présentent-elles des différences fondamentales, qui correspondent à des différences de fonctionnement fondamentales.

Et l'invention vise en particulier à :
- préserver les avantages du procédé de FR 2 796 491 (entre autres le contrôle de la haute et basse pression pour maîtriser finement les contraintes appliquées à l'ensemble à couper, ainsi que le fait de laisser largement ledit ensemble à couper se déformer librement), lesdits avantages étant exclus par la configuration enseignée par US 6 221 740,
- tout en permettant une coupe efficace au niveau d'une interface de fragilisation qui aurait, été réalisée par tout moyen (par exemple par implantation), ce qui n'est pas actuellement accessible par le procédé et dispositif de FR 2 796 491 qui est comme on l'a dit strictement limité à la coupe au niveau d'une interface de fragilisation correspondant à une interface de collage.

Afin d'atteindre ce but, l'invention propose selon un premier aspect un procédé de coupe comprenant toutes les caractéristiques de la revendication 1.

Des aspects préférés, mais non limitatifs du procédé selon l'invention sont les suivants :
- on sépare de manière étanche la région de haute pression de chaque région de basse pressions,
- on place l'ensemble à couper dans une enceinte, dans laquelle on définit par des joints toriques coopérant avec l'ensemble à couper la région de haute pression et chaque région de basse pression,
- la haute pression est contrôlée de manière à augmenter progressivement dans la région de haute pression,
- on établit une boucle de régulation pour établir la haute pression en fonction de la progression du front de décollement généré lors de la coupe,
- on établit la haute pression par l'intermédiaire d'une alimentation en fluide haute pression indépendante de chaque lame,
- on établit la haute pression par l'intermédiaire d'une lame, comportant des moyens d'alimentation de fluide haute pression,
- on exerce en outre une action de traction et/ou de cisaillement sur les deux faces principales de l'ensemble à couper,

Selon un deuxième aspect, l'invention propose par ailleurs un dispositif de coupe comprenant toutes les caractéristiques de la revendication 9.

Des aspects préférés, mais non limitatifs du dispositif selon l'invention sont les suivants :
- le dispositif comprend des moyens pour établir une étanchéité entre la région de haute pression et chaque région de basse pression,
- le dispositif comprend des moyens d'alimentation haute pression indépendants de chaque lame du dispositif,
- au moins une lame du dispositif comporte un canal interne d'alimentation en fluide haute pression,
- le dispositif comprend une boucle de régulation de la montée en haute pression en fonction de la progression du front de décollement généré lors de la coupe,
- le dispositif comprend en outre des moyens pour exercer une action mécanique complémentaire sur les deux faces principales respectives de l'ensemble à couper,
- ladite action mécanique complémentaire peut être une traction perpendiculaire aux faces principales de l'ensemble à couper, et/ou une contrainte de cisaillement orientée dans le plan de l'interface de fragilisation.

D'autres aspects, buts et avantages de l'invention apparaîtront mieux à la lecture de la description suivante de formes préférées de réalisation de l'invention, faite en référence aux dessins annexés sur lesquels :
- la figure 1a est une représentation schématique en élévation de côté d'une première variante principale d'un dispositif selon l'invention, le dispositif comprenant une lame qui est ici représentée avant l'attaque d'un ensemble à couper,
- la figure 1b est une vue similaire du même dispositif, la lame ayant commencé à attaquer l'ensemble à décoller,
- la figure 1c est une vue schématique de dessus du même dispositif, la lame du dispositif étant dans une position correspondant à la figure 1b,
- la figure 2a est une représentation schématique en élévation de côté d'un dispositif correspondant à une deuxième variante principale de l'invention,
- la figure 2b est une vue schématique de dessus correspondant à la variante de la figure 2a.

En introduction à la description qui suit de différentes variantes de réalisation de l'invention, on précise que les exemples décrits ci-dessous illustrent la coupe d'un ensemble à couper 10, comprenant deux couches de matériaux séparées par une interface de fragilisation.

Les deux couches situées de part et d'autre de l'interface de fragilisation peuvent être réalisées dans le même matériau, ou dans des matériaux différents.

L'interface de fragilisation elle-même peut être réalisée par tout moyen connu en soi. En particulier, cette interface de fragilisation peut avoir été réalisée par une implantation d'espèce comme mentionné ci-dessus, ou encore par tout autre moyen connu (constitution d'une mince couche poreuse correspondant à l'interface de fragilisation entre les deux couches de matériaux à couper, collage, etc.).

On précise également que si, sur les figures qui illustrent la présente description, l'ensemble à couper se présente sous la forme de deux couches relativement épaisses, dans la réalité ces couches peuvent être extrêmement fines.

En particulier, dans une application préférée de l'invention, l'ensemble à couper peut être un substrat de type SOI (ou de manière plus générale un substrat de type SOA - Silicon On Anything selon la terminologie anglo-saxonne répandue, ou même de type AOA - Anything On Anything selon la terminologie anglo-saxonne répandue).

Dans la suite de ce texte on nommera « wafer » l'ensemble à couper 10.

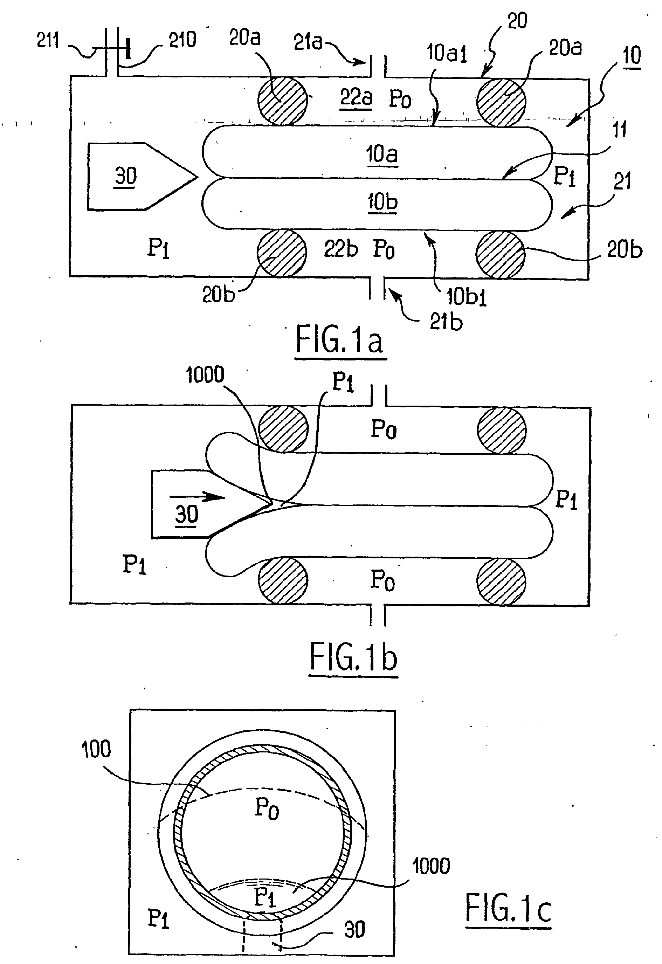

En référence maintenant à la figure 1a, on a représenté schématiquement un wafer 10 comportant deux couches 10a et 10b, séparées par une interface de fragilisation 11.

La couche 10a définit ainsi par sa face qui est opposée à l'interface de fragilisation 11, une première face principale 10a1 du wafer 10. La couche 10b définit de manière symétrique une deuxième face principale 10b1 du wafer.

Le wafer 10 comprend ainsi :
- deux couches 10a et 10b séparées par une interface de fragilisation 11,
- les deux couches 10a et 10b définissant au niveau de leurs faces externes respectives les deux faces principales 10a1 et 10b1 du wafer,
- l'interface de fragilisation 11 définissant à la périphérique du wafer une ligne circulaire que l'on dénommera "couronne d'interface".

Le wafer 10 a typiquement une forme circulaire, les deux couches 10a et 10b se présentant alors sous la forme de deux disques superposés, reliés par l'interface de fragilisation 11.

Comme on l'a dit, cette interface de fragilisation peut avoir été réalisée par tout moyen connu en soi.

On précise que le wafer 10 a pu également subir préalablement un traitement spécifique, afin de faciliter la coupe selon l'interface de fragilisation 11.

Un tel traitement préalable peut par exemple consister à faire subir au wafer 10 un traitement thermique du type recuit sous haute température.

Plus particulièrement dans le cas d'une interface de fragilisation réalisée par implantation, un tel traitement thermique préalable peut permettre de « surfragiliser » l'interface 11 - étant entendu que le budget thermique associé à un tel traitement préalable doit demeurer inférieur au budget thermique nécessaire pour complètement cliver les deux couches 10a et 10b.

De la sorte, la coupe (c'est-à-dire l'opération permettant de définitivement disjoindre les deux tranches 10a et 10b l'une dé l'autre) est ensuite facilitée.

Le wafer est placé dans une enceinte 20 qui permet de définir de manière étanche au moins une zone de haute pression et une zone de basse pression.

Plus précisément, l'enceinte 20 contient deux joints toriques 20a et 20b qui sont plaqués de manière étanche contre les faces principales respectives 10a1 et 10b1 du wafer.

Chaque joint torique est ainsi disposé de manière concentrique au wafer.

Chaque joint torique 20a, 20b est par ailleurs en contact étanche avec la paroi de l'enceinte 20. Une telle configuration produit ainsi dans l'enceinte :
- une zone périphérique 21, qui entoure le wafer 10 au niveau de sa paroi latérale qui comprend la zone correspondant à la couronne d'interface,
- et deux zones 22a et 22b qui sont délimitées par les joints toriques respectifs 20a et 20b, et qui sont situés en regard des deux faces principales respectives du wafer.

On remarquera sur la figure 1a la présence d'une arrivée de fluide 210 pour alimenter la région 21 avec un fluide sous une pression contrôlée (par exemple par une vanne 211).

La région 21 est dite région de "haute pression", la pression contrôlée du fluide alimentant cette région étant, comme on va le voir, définie de manière à être supérieure à la pression qui règne dans les zones 22a et 22b.

On peut en effet également contrôler la pression qui règne dans ces deux régions 22a et 22b, par tout moyen connu en soi.

On précise que le fluide qui remplit les régions 22a et 22b peut être tout simplement de l'air, ou encore un mélange de gaz spécifique, ou de manière générale tout fluide ou mélange de fluide adapté au contrôlé de la pression sur les faces externes du wafer.

De même, le fluide arrivant par l'alimentation 210 peut être tout fluide adapté pour faire régner dans la région 21 une haute pression, et favoriser comme on va le comprendre la coupe des deux couches de wafer.

On précise que le fluide utilisé pour établir une haute pression peut avoir des propriétés chimiques permettant d'attaquer l'interface 11 et de faciliter ainsi la coupe (par exemple, dans le cas de la coupe d'une couche d'oxyde, on pourra utiliser un fluide du type HF liquide ou gazeux).

A titre d'exemple pas conforme à l'invention, en relation avec les figures 1a à 1c, la pression des régions 22a et 22b peut être contrôlée par l'intermédiaire de deux évents respectifs 21a et 21b qui permettent à l'air (ou de manière générale au fluide) contenu dans ces deux régions respectives de communiquer librement avec l'atmosphère ambiante entourant l'enceinte 20.

Dans ce cas, la « basse pression » des régions 22a et 22b est contrôlée de manière à correspondre à la pression environnante. Dans le cas d'une enceinte placée dans de l'air à pression atmosphérique, la basse pression est ainsi contrôlée de manière à être égale à cette pression atmosphérique.

On remarque également (en particulier sur les figures 1a et 1b) la présence d'une lame 30 qui est placée dans la région de haute pression 21.

La lame 30 est placée dans l'axe de l'interface de fragilisation 11, le bord d'attaque de cette lame étant disposé au niveau de la couronne d'interface correspondant à cette interface de fragilisation 11.

La lame 30 est en outre montée sur des moyens spécifiques permettant de commander et de contrôler son déplacement dans le plan de l'interface de fragilisation 11 (ces moyens spécifiques pouvant être de tout type connu en soi, et n'étant pas représentés sur les figures par souci de clarté).

On précise que les joints toriques 20a et 20b peuvent être remplacés par des joints ayant une autre forme, ou par tout moyen spécifique permettant d'établir une étanchéité entre la région 21 et les régions 22a et 22b.

On pourra en particulier adapter la configuration des régions de basse pression pour favoriser la déformation d'une des deux couches 10a, 10b du wafer, notamment en fonction des matériaux respectifs constituant les deux couches du wafer.

En effet, dans le cas de deux couches réalisées dans des matériaux différents, il est possible que pendant la coupe on souhaite favoriser plus particulièrement la déformation d'une des deux couches. Dans ce cas, on pourra prévoir de ne former une zone de basse pression qu'en regard de la face principale du wafer correspondant à cette couche particulière.

On selon l'invention, on contrôle séparément et différemment les « basses pressions » des deux régions 22a et 22b, de manière à exercer sur une des deux couches un différentiel de pression - et donc une contrainte - plus fort que sur l'autre couche.

On précise que la pression du fluide d'alimentation de la région de haute pression 21 peut être contrôlée de manière à établir progressivement une haute pression dans cette région et on pourra à cet effet définir toute séquence de commande pour réaliser cette montée en pression, de manière plus ou moins rapide et/ou plus ou moins continue.

En référence maintenant plus précisément aux figures 1b et 1c, en conjonction avec l'établissement d'une haute pression P1 dans la région 21 (la pression P1 étant supérieure à la pression P0 régnant dans les régions 22a et 22b), on commande le déplacement de la lame 30 de manière à ce que le bord d'attaque de cette lame attaque le wafer au niveau de sa couronne d'interface.

On rappelle que la couronne d'interface correspond à l'intersection entre l'interface de fragilisation 11 et la périphérie du wafer 10.

On précise également que si les deux couches du wafer 10 ont dans les représentations très schématiques des figures des bords chanfreinés, il est également possible que ces bords soient plus ou moins vifs.

La position du bord d'attaque de la lame selon la direction perpendiculaire aux faces principales du wafer à couper (c'est-à-dire selon la direction "verticale") est précisément définie, de manière à ce que lors de son déplacement, le bord d'attaque de la lame attaque le wafer au niveau de cette couronne d'interface.

Toutefois, il est également possible d'associer à la lame 30 des moyens autorisant une certaine liberté selon cette direction verticale, afin de permettre l'auto-ajustement de la position verticale du bord d'attaque de la lame lors de l'entrée en contact de ladite lame avec la couronne d'interface.

Un tel auto-ajustement sera en particulier mis en oeuvre lorsque la couronne d'interface est définie par des bords chanfreinés des couches 10a et 10b, cette couronne d'interface se trouvant alors au fond d'un chanfrein annulaire qui guide le bord d'attaque de la lame vers l'interface de fragilisation 11, lors de l'attaque.

La figure 1b représente le dispositif selon l'invention, la lame 30 ayant attaqué l'interface de fragilisation 11 et ayant commencé à écarter les deux couches 10a et 10b.

On rappelle que les échelles des différents éléments représentés sur les figures (couches 10a et 10b, lame 30, ...) ne sont pas représentatives de la réalité.

Par exemple, lors de l'attaque d'un SOI par la lame, les deux couches 10a et 10b ne s'écartent que de l'épaisseur de la lame qui peut être de l'ordre du millimètre, et la déformation des couches 10a et 10b représentée en particulier sur la figure 1b est très fortement exagérée.

En tout état de cause, la pénétration de la lame entre les deux couches 10a et 10b permet de générer et de propager un front de décollement entre les deux couches, ledit front de décollement 100 étant schématiquement représenté sur la figure 1c.

On connaît dans le domaine de la coupe de structure SOI par exemple de tels fronts de décollement, qu'il est possible d'observer (par exemple par mesure de la réflexion et/ou de la transmission d'un rayonnement lumineux - par exemple infrarouge - avec lequel on illumine le wafer que l'on coupe).

On précise que la lame 30 n'attaque le wafer que sur une petite portion de sa périphérie.

A cet égard, le contour de la lamé en vue de dessus peut correspondre à une géométrie saillante attaquant le wafer sur une faible portion seulement de sa périphérie, comme représenté sur la figure 1c.

Il est également possible de définir une géométrie différente pour la lame 30, et donner à celle-ci par exemple un profil en vue de dessus (correspondant à la vue de la figure 1c) concave en « croissant de lune », le bord d'attaque de la lame coopérant alors avec tout un secteur angulaire de la périphérie du wafer.

En tout état de cause, lors de l'attaque du wafer par la lame 30 et du début d'écartement entre les deux couches 10a et 10b (les joints toriques 20a et 20b étant disposés en retrait de la périphérie du wafer 10, de sorte qu'un tel écartement initial est possible), le fluide sous haute pression de la région 21 peut pénétrer (entre autres sur les côtés de la lame) entre les deux couches 10a et 10b, sur les côtés et en avant de cette lame 30.

De la sorte, on crée entre les deux couches 10a et 10b et en avant de la lame 30 une zone 1000 dans laquelle la pression est sensiblement égale à P1.

Dès que la lame a suffisamment progressé entre les deux couches 10a et 10b pour que cette-zone 1000 se trouve à l'aplomb des faces principales du wafer qui sont encerclées par les joints 20a et 20b, au moins une partie des couches 10a et 10b est alors soumise à une contrainte en écartement de l'autre couche, du fait du différentiel de pression (P1-P0) à laquelle ladite partie de la couche est exposée.

Il en résulte un écartement facilité des deux couches 10a et 10b.

On notera à cet égard que la configuration du dispositif selon l'invention permet de laisser ces deux couches 10a et 10b extrêmement libres de se déformer en écartement l'une de l'autre selon la direction verticale (contrairement à ce qu'on obtient avec la configuration' du US 6 221 740).

Ainsi, l'action combinée de la lame et de la contrainte générée par les différentiels de pression (P1-P0) permet de réaliser la coupe du wafer dans les meilleures conditions.

On précise que l'élasticité des joints 20a et 20b est de préférence définie de manière à :
- Autoriser à un certain écartement des couches 10a et 10b l'une de l'autre, de manière à permettre l'achèvement de la coupe,
- Tout en garantissant une bonne étanchéité entre la région de haute pression et chaque région de basse pression.

On précise également qu'on définira en fonction des paramètres souhaités pour l'opération de coupe (prenant en particulier en compte les matériaux constitutifs des deux couches du wafer) les niveaux de pression P1 et P0.

En tout état de cause, l'établissement progressif d'une surpression P1 dans la région 21 favorise le déroulement de l'opération de coupe en évitant toute rupture des couches 10a et 10b.

Il est également possible d'établir une boucle de contrôle pour piloter la montée en pression dans la région 21, en fonction de l'observation de la progression du front de décollement 100. Cette observation du front de décollement peut être réalisée par exemple par observation des caractéristiques optiques de la surface du wafer - en' particulier en visible et/ou en infrarouge.

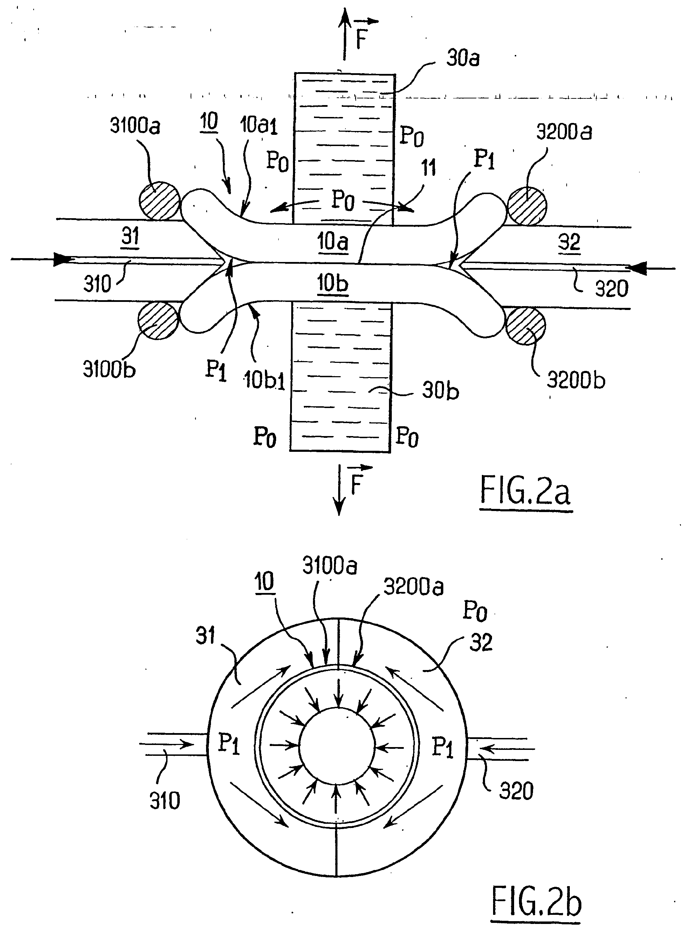

En référence maintenant aux figures 2a et 2b, on a illustré une deuxième variante principale de l'invention.

La figure 2a expose ainsi le même wafer 10, soumis à l'attaque d'au moins une lame qui comporte elle-même un moyen d'alimentation en fluide sous haute pression.

Dans l'exemple de la figure 2a, le wafer 10 est soumis à l'attaque de deux lames mobiles 31 et 32, diamétralement opposées de part et d'autre du wafer dans le plan correspondant à l'interface de fragilisation 11.

Toutefois, une de ces deux lames peut demeurer fixe et constituer de la sorte une cale de maintien du wafer. Cette cale contribue également à établir une étanchéité entre les régions de haute et de basse pression, grâce aux joints qui sont fixés sur ses deux faces (la configuration et le rôle de ces joints étant expliquées plus loin dans ce texte).

Chaque lame 31, 32 comporte un canal interne 310, 320 d'alimentation, raccordé à une réserve de fluide sous haute pression, des moyens étant ici encore prévus pour contrôler l'établissement d'une haute pression P1 dans ledit canal, et ce canal débouche au niveau du bord d'attaque de la lame qui le contient.

Dans cette variante, l'établissement d'une surpression au niveau de la couronne d'interface est assurée par l'injection de fluide sous pression par le canal de la lame, après l'attaque du wafer par la ou les lame(s) (c'est à dire une fois que les lames sont dans la position de la figure 2b dans laquelle est établie une étanchéité entre les régions de haute et de basse pression).

Et ici encore, on crée de la sorte une région de haute pression délimitée de manière étanche au niveau de la couronne d'interface, qui attaque l'interface de fragilisation et crée en avant de chaque lame un zone de surpression, de manière à soumettre la (ou les) couche(s) du wafer à un différentiel de pression.

Dans l'example des figures 2a et 2b, les zones de basse pression situées en regard des faces principales du wafer correspondent simplement à des zones dans lesquelles ces faces du wafer sont exposées à la pression atmosphérique ambiante (notée P0), ce qui n'est pas conforme à l'invention.

Selon l'invention est cependant nécessaire de définir de manière étanche de zones de basse pression en regard des faces principales (ou d'une seulement de ces faces principales) du wafer, en particulier en plaçant comme décrit ci dessus le wafer dans une enceinte et en définissant par des joints des régions étanches de l'enceinte, la surpression P1 étant toujours assurée par l'intermédiaire d'un canal interne de la lame (ou des lames) qui attaque(nt) le wafer.

On précise que dans ce cas, des moyens complémentaires sont également prévus pour garantir une étanchéité entre les régions de basse pression (en particulier les régions se trouvant en regard des faces principales du wafer), et les régions de haute pression (en particulier les régions situées en avant des lames 31 et 32 lors de l'attaque du wafer par les lames - voir figure 2a).

Ces moyens complémentaires peuvent prendre comme sur les figures 2a et 2b la forme de portions de joints toriques 3100a, 3100b, 3200a et 3200b.

Comme cela apparaît plus particulièrement sur la figure 2a, deux joints 3100a et 3100b sont ainsi fixés sur les deux faces respectives de dessus et de dessous de la lame 31.

La lame a une géométrie générale en forme de demi anneau (voir aussi figure 2b), dont le diamètre intérieur (diamètre de l'évidemment central du demi-anneau) est inférieur au diamètre externe de la couronne périphérique du wafer, d'une distance correspondant à la profondeur d'attaque désirée pour la lame dans le wafer.

Et les deux lames 31 et 32 étant identiques et disposées symétriquement (de même que les joints toriques qu'elles portent), le resserrement des deux lames produit un anneau qui attaque la couronne du wafer sur toute sa périphérie, en ne pénétrant le wafer que d'une profondeur désirée.

Chaque portion de joint torique 3100a, 3100b a ainsi lui-même la forme d'un demi-anneau, qui est fixé sur sa face de lame à proximité du bord d'attaque de la lame.

Plus précisément, la distance entre le joint et le bord d'attaque est définie de manière à ce que lors de l'attaque du wafer par la lame, la partie périphérique de la couche 10a, 10b respective se trouvant en regard du joint vienne en appui étanche sur ledit joint.

On crée ainsi une étanchéité entre l'environnement externe du wafer (exposé à la « basse » pression contrôlée dans une enceinte étanche pour avoir toute valeur), et les régions du wafer dans lesquelles on souhaite établir une surpression (régions situées entre les deux couches 10a et 10b, en avant du bord d'attaque de la lame).

On précise que les lames 31 et 32 sont identiques et disposées symétriquement par rapport au wafer, de même que les joints qu'elles portent.

Et au terme du resserrement des lames sur le wafer, les extrémités du joint 31 00a viennent en contact étanche avec celles du joint 3200a de la lame opposée, de manière à créer sur le dessus de la lame un joint torique annulaire étanche.

Et il en est de même sous la lame, avec les joints 3100b et 3200b.

On établit de la sorte une étanchéité complète entre les régions de basse et de haute pression.

La figure 2b fait apparaître de manière schématique la géométrie particulière des lames 31 et 32 qui, dans ce mode de réalisation ont chacune en vue de dessus la forme d'un demi-anneau.

Dans ce cas, les deux lames 31 et 32 se rapprochent l'une de l'autre jusqu'à ce que les portions rectilignes de leurs bords d'attaque (c'est à dire les portions correspondant à un rayon de l'anneau, le bord d'attaque de chaque lame comprenant entre ces deux portions périphériques un bord d'attaque dont le contour en vue de dessus correspond au contour de l'évidemment central du demi-anneau) se rencontrent, la coupe étant alors achevée.

On précise toutefois qu'ici encore il n'est pas nécessaire que la lame pénètre toute la surface du wafer.

En effet, dans les différentes variantes de la réalisation de l'invention, il est possible de réaliser totalement l'opération de coupe en ne faisant pénétrer la lame que sur une profondeur limitée du wafer, et de jouer sur le différentiel de pression (P1 - P0) pour réaliser la coupe.

On remarque également sur la figure 2a la présence de deux éléments de préhension 30a et 30b, en prise avec les faces respectives 10a1 et 10b1 du wafer.

Ces éléments de préhension peuvent comprendre par exemples des ventouses ou des moyens de mise en dépression de la face de l'élément de préhension qui en contact avec la face principale du wafer.

Les éléments 30a et 30b peuvent ainsi favoriser encore l'écartement des couches 10a et 10b de manière à faciliter la coupe.

On précise que ces éléments peuvent être asservis en écartement l'un de l'autre (de manière à exercer une traction facilitant directement l'écartement des couches 10a et 10b).

Il est également possible de commander le déplacement de ces éléments 30a et 30b dans des directions du plan de l'interface de fragilisation 11, les deux éléments ayant des déplacements dans des directions opposées de manière à générer des contraintes de cisaillement pour favoriser encore la coupe des couches 10a et 10b.

## Revendications

1. Procédé de coupe de haute précision de deux couches de matériau (10a, 10b) formant un ensemble à couper (10) qui présente deux faces principales, le procédé comprenant :
• la création entre les deux couches de matériau d'une interface de fragilisation (11) par l'intermédiaire de laquelle les deux couches de matériau sont solidaires, ladite interface définissant à la périphérie de l'ensemble à couper une couronne d'interface,
• la formation d'une première région (21) dite de haute pression située au niveau de la couronne d'interface de l'ensemble à couper,
• la formation d'au moins une deuxième région (22a, 22b) dite de basse pression dont la pression est contrôlée en regard d'une partie au moins d'une face principale de l'ensemble à couper,
• l'alimentation de la région de haute pression avec un fluide dont la pression est contrôlée, et
• en combinaison avec l'alimentation en haute pression on attaque la couronne d'interface de l'ensemble à couper avec au moins une lame (30,31, 32),
**caractérisé en ce qu'**on établit une région de basse pression en regard de chaque face principale respective de l'ensemble à couper et **en ce qu'**on contrôle séparément et différemment les pressions des deux régions de basse pression.

2. Procédé selon la revendication précédente, **caractérisé en ce qu'**on sépare de manière étanche la région de haute pression de chaque région de basse pression.

3. Procédé selon la revendication précédente **caractérisé en ce qu'**on place l'ensemble à couper dans une enceinte (20), dans laquelle on définit par des joints toriques coopérant avec l'ensemble à couper la région de haute pression et chaque région de basse pression.

4. Procédé selon l'une des revendications précédentes **caractérisé en ce que** la haute pression est contrôlée de manière à augmenter progressivement dans la région de haute pression.

5. Procédé selon la revendication précédente **caractérisé en ce qu'**on établit une boucle de régulation pour établir la haute pression en fonction de la progression du front de décollement (100) généré lors de la coupe.

6. Procédé selon l'une des revendications précédentes **caractérisé en ce qu'**on établit la haute pression par l'intermédiaire d'une alimentation (210,211) en fluide haute pression indépendante de chaque lame.

7. Procédé selon l'une des revendications 1 à 5 **caractérisé en ce qu'**on établit la haute pression par l'intermédiaire d'une lame (31,32), comportant des moyens (310,320) d'alimentation de fluide haute pression.

8. Procédé selon l'une des revendications précédentes, **caractérisé en ce qu'**on exerce en outre une action de traction et/ou de cisaillement sur les deux faces principales de l'ensemble à couper.

9. Dispositif de coupe de haute précision de deux couches de matériau (10a, 10b) formant un ensemble à couper (10) qui présente deux faces principales (10a1, 10b1), les deux couches de l'ensemble à couper étant séparées par une interface de fragilisation (11), ladite interface définissant à la périphérie de l'ensemble à couper une couronne d'interface,
• le dispositif comprenant: des moyens (20,210, 310,320) pour établir au niveau de la couronne d'interface de l'ensemble à couper une première région (21) dite de haute pression,
• des moyens (21 a, 21 b) pour établir en regard d'une partie au moins d'une face principale de l'ensemble à couper, une région (22a, 22b) dite de basse pression,
• et au moins une lame (30,31, 32) pour attaquer l'ensemble à couper au niveau de sa couronne d'interface,
**caractérisé en ce que** le dispositif comprend des moyens pour établir et contrôler séparément les pressions de deux régions de basse pression (22a, 22b) associées aux deux faces principales respectives de l'ensemble à couper.

10. Dispositif selon la revendication précédente **caractérisé en ce que** le dispositif comprend des moyens (20,20a, 20b, 3100a, 3100b, 3200a, 3200b) pour établir une étanchéité entre la région de haute pression et chaque région de basse pression.

11. Dispositif selon l'une des revendications 9 à 10 **caractérisé en ce que** le dispositif comprend des moyens d'alimentation haute pression (210,211) indépendants de chaque lame du dispositif.

12. Dispositif selon l'une des revendications 9 ou 10 **caractérisé en ce que** le dispositif comprend au moins une lame (31,32) du dispositif comporte un canal interne d'alimentation en fluide haute pression.

13. Dispositif selon l'une des revendications 10 à 12 **caractérisé en ce que** le dispositif comprend une boucle de régulation de la montée en haute pression en fonction de la progression du front de décollement (100) généré lors de la coupe.

14. Dispositif selon l'une des revendications 10 à 13 **caractérisé en ce que** le dispositif comprend en outre des moyens (30a, 30b) pour exercer une action mécanique complémentaire sur les deux faces principales respectives de l'ensemble à couper.

15. Dispositif selon la revendication précédente **caractérisé en ce que** ladite action mécanique complémentaire peut être une traction perpendiculaire aux faces principales de l'ensemble à couper, et/ou une contrainte de cisaillement orientée dans le plan de l'interface de fragilisation.

## Claims

1. A method for high-precision cutting of two layers of material (10a, 10b) forming an assembly to be cut (10) that has two principal surfaces, said method comprising:
- creating between the two layers of material an embrittlement interface (11) by means of which the two layers of material are joined, said interface defiling an interface ring at the periphery of the assembly to be cut,
- formation of a first high-pressure zone (21) whose border comprises at least one part of the interface ring of the assembly to be cut,
- formation of at least one second so-called low-pressure zone (22a, 22b), whose pressure is controlled relative to one part at least of a principal surface of the assembly to be cut,
- supplying the high-pressure zone with a fluid, whose pressure is controlled, and
- in combination with the high-pressure supply, the interface ring of the assembly to be cut is attacked by at least one blade (30, 31, 32),
**characterised in that** a low-pressure zone is established across from each principal surface respective of the assembly to be cut and **in that** the pressures of the two low-pressure zones are controlled separately and differently.

2. A method according to the above claim, **characterised in that** the high-pressure zone is separated from the low-pressure zone in a tight manner.

3. A method according to the above claim, **characterised in that** the assembly to be cut is placed in a receptacle (20), wherein the high-pressure zone and each low-pressure zone are defined by O-rings cooperating with the assembly to be cut.

4. A method according to any of the above claims, **characterised in that** the high pressure is controlled so as to progressively increase in the high-pressure zone.

5. A method according to the above claim, **characterised in that** a control loop is established for establishing the high pressure as a function of the progression of the separation front (100) created at the time of cutting.

6. A method according to any of the above claims, **characterised in that** the high pressure is established by means of an independent supply (210, 211) of high-pressure fluid for each blade.

7. A method according to claims 1 to 5, **characterised in that** the high pressure is established by means of a blade (31, 32) comprising means (310, 320) to supply high-pressure fluid.

8. A method according to any of the above claims, **characterised in that** a traction and/or shearing action is also applied on the two principal surfaces of the assembly to be cut.

9. A device for high-precision cutting of two layers of material (10a, 10b) forming an assembly to be cut (10) having has two principal surfaces (10a1, 10b1), the two layers of the assembly to be cut being separated by an embrittlement interface (11), said interface defining an interface ring at the periphery of the assembly to be cut,
the device comprising
- means (20, 210, 310, 320) for establishing a first so-called high-pressure zone (21) at the level of the interface ring of the assembly to be cut,
- means (21a, 21b) for establishing a so-called low-pressure zone (22a, 22b) relative to one part at least of one principal face of the assembly to be cut,
- and at least one blade (30, 31, 32) for attacking the assembly to be cut at its interface ring,
**characterised in that** the device comprises means for establishing and separately controlling the pressures of the two low-pressure zones (22a, 22b) associated with the respective two surfaces of the assembly to be cut.

10. A device according to the above claim, **characterised in that** the device comprises means (20, 20a, 20b, 3100a, 3100b, 3200a, 3200b) for establishing tightness between the high-pressure zone and each low-pressure zone.

11. A device according to any of claims 9 to 10, **characterised in that** the device comprises independent high-pressure supply means (210, 211) for each blade of the device.

12. A device according to any of claims 9 or 10, **characterised in that** the device comprises at least one blade (31, 32) of the device comprising an internal supply conduit for high-pressure fluid.

13. A device according to any of claims 10 to 12, **characterised in that** the device comprises a control loop for the increase of high pressure as a function of the progression of the separation front (100) created at the time of cutting.

14. A device according to any of claims 10 to 13, **characterised in that** the device also comprises means (30a, 30b) for applying a complementary mechanical action on the respective two principal faces of the assembly to be cut.

15. A device according to the above claim, **characterised in that** said complementary mechanical action can be a traction perpendicular to the principal surfaces of the assembly to be cut and/or a shearing force oriented in the plane of the embrittlement interface.

## Patentansprüche

1. Verfahren zum Präzisionsschneiden zweier Materialschichten (10a, 10b), die eine zu schneidende Einheit (10) bilden, die zwei Hauptflächen hat, wobei das Verfahren Folgendes umfasst:
• Erzeugen einer Schwächungszwischenschicht (11) zwischen den beiden Materialschichten, mittels der die beiden Materialschichten fest miteinander verbunden sind, wobei die Zwischenschicht am Rand der zu schneidenden Einheit einen Zwischenschichtkranz definiert,
• Ausbilden einer ersten Zone (21), die als Zone hohen Drucks bezeichnet wird und die sich im Bereich des Zwischenschichtkranzes der zu schneidenden Einheit befindet,
• Ausbilden wenigstens einer zweiten Zone (22a, 22b), die als Zone niedrigen Drucks bezeichnet wird und für die der Druck wenigstens im Bereich eines Teils einer Hauptfläche der zu schneidenden Einheit gesteuert wird,
• Versorgen der Zone hohen Drucks mit einem Fluid, dessen Druck gesteuert wird, und
• Bearbeiten des Zwischenschichtkranzes der zu schneidenden Einheit mit wenigstens einer Klinge (30, 31, 32) in Kombination mit der Versorgung mit hohem Druck,
**dadurch gekennzeichnet, dass** eine Zone niedrigen Drucks jeweils im Bereich jeder Hauptfläche der zu schneidenden Einheit eingerichtet wird und dadurch, dass der Druck der beiden Zonen niedrigen Drucks getrennt und unterschiedlich gesteuert wird.

2. Verfahren nach dem vorhergehenden Anspruch, **dadurch gekennzeichnet, dass** die Zone hohen Drucks auf abgedichtete Weise von jeder Zone niedrigen Drucks abgetrennt wird.

3. Verfahren nach dem vorhergehenden Anspruch, **dadurch gekennzeichnet, dass** die zu schneidende Einheit in einer Kammer (20) platziert wird, in der durch torusförmige Dichtungen, die mit der zu schneidenden Einheit zusammenarbeiten, die Zone hohen Drucks und jede der Zonen niedrigen Drucks definiert werden.

4. Verfahren nach einem der vorhergehenden Ansprüche, **dadurch gekennzeichnet, dass** der hohe Druck derart gesteuert wird, dass er in der Zone hohen Drucks progressiv zunimmt.

5. Verfahren nach dem vorhergehenden Anspruch, **dadurch gekennzeichnet, dass** eine Regelschleife eingerichtet wird, um den hohen Druck in Abhängigkeit vom Fortschritt der beim Schneiden erzeugten Ablösefront (100) bereitzustellen.

6. Verfahren nach einem der vorhergehenden Ansprüche, **dadurch gekennzeichnet, dass** der hohe Druck durch eine unabhängige Versorgung (210, 211) mit einem Fluid hohen Drucks für jede Klinge bereitgestellt wird.

7. Verfahren nach einem der Ansprüche 1 bis 5, **dadurch gekennzeichnet, dass** der hohe Druck durch eine Klinge (31, 32) bereitgestellt wird, die Mittel (310, 320) zur Versorgung mit einem Fluid hohen Drucks umfasst.

8. Verfahren nach einem der vorhergehenden Ansprüche, **dadurch gekennzeichnet, dass** auf die beiden Hauptflächen der zu schneidenden Einheit außerdem eine Zug- und/oder Scherungsbeanspruchung einwirkt.

9. Vorrichtung zum Präzisionsschneiden zweier Materialschichten (10a, 10b), die eine zu schneidende Einheit (10) bilden, die zwei Hauptflächen (10a1, 10b1) hat, wobei die beiden Schichten der zu schneidenden Einheit durch eine Schwächungszwischenschicht (11) getrennt sind und wobei die Zwischenschicht am Rand der zu schneidenden Einheit einen Zwischenschichtkranz definiert,
wobei die Vorrichtung Folgendes umfasst:
• Mittel (20, 210, 310, 320), um im Bereich des Zwischenschichtkranzes der zu schneidenden Einheit eine erste Zone (21) herzustellen, die als Zone hohen Drucks bezeichnet wird,
• Mittel (21a, 21b), um wenigstens im Bereich eines Teils einer Hauptfläche der zu schneidenden Einheit eine Zone (22a, 22b) herzustellen, die als Zone niedrigen Drucks bezeichnet wird,
• und wenigstens eine Klinge (30, 31, 32) zur Bearbeitung der zu schneidenden Einheit im Bereich ihres Zwischenschichtkranzes,
**dadurch gekennzeichnet, dass** die Vorrichtung Mittel umfasst, um den Druck der beiden Zonen niedrigen Drucks (22a, 22b), die zu den jeweiligen beiden Hauptflächen der zu schneidenden Einheit gehören, getrennt zu steuern und herzustellen.

10. Vorrichtung nach dem vorhergehenden Anspruch, **dadurch gekennzeichnet, dass** die Vorrichtung Mittel (20, 20a, 20b, 3100a, 3100b, 3200a, 3200b) umfasst, um zwischen der Zone hohen Drucks und jeder der Zonen niedrigen Drucks eine Abdichtung herzustellen.

11. Vorrichtung nach einem der Ansprüche 9 bis 10, **dadurch gekennzeichnet, dass** die Vorrichtung unabhängige Mittel zur Versorgung mit hohem Druck (210, 211) für jede Klinge der Vorrichtung umfasst.

12. Vorrichtung nach einem der Ansprüche 9 oder 10, **dadurch gekennzeichnet, dass** wenigstens eine Klinge (31, 32) der Vorrichtung einen inneren Kanal zur Versorgung mit einem Fluid hohen Drucks umfasst.

13. Vorrichtung nach einem der Ansprüche 10 bis 12, **dadurch gekennzeichnet, dass** die Vorrichtung eine Regelschleife für den Anstieg des hohen Drucks in Abhängigkeit vom Fortschreiten der beim Schneiden erzeugten Ablösefront (100) umfasst.

14. Vorrichtung nach einem der Ansprüche 10 bis 13, **dadurch gekennzeichnet, dass** die Vorrichtung außerdem Mittel (30a, 30b) umfasst, um auf die jeweiligen beiden Hauptflächen der zu schneidenden Einheit eine zusätzliche mechanische Beanspruchung auszuüben.

15. Vorrichtung nach dem vorhergehenden Anspruch, **dadurch gekennzeichnet, dass** die zusätzliche mechanische Beanspruchung ein Zug senkrecht zu den Hauptflächen der zu schneidenden Einheit und/oder eine in der Ebene der Schwächungszwischenschicht ausgerichtete Scherungsbeanspruchung sein kann.
